# EUROPEAN PATENT APPLICATION

(11) **EP 0 926 730 A2**
(43) Date of publication of application: **30.06.1999**
(21) Application number: 98310316.9
(22) Date of filing: 16.12.1998
(51) Int. Cl.: H01L 23/16, H01L 23/31

(54) **Ball grid array package and method of construction thereof**

(30) Priority: 19.12.1997 US 68328 P
(71) Applicant: TEXAS INSTRUMENTS INCORPORATED, Dallas Texas 75265 (US)
(72) Inventor: Edwards, Darvin R., Garland, Texas 75044 (US); Groothuis, Steven K., McMurray, Pennsylvania 15317-2636 (US)
(74) Representative: Harris, Ian Richard

(57) **Abstract**

A ball grid array package (24) is disclosed. The package (24) includes an interposer (16) having traces on a first surface and associated solder balls (20) on an opposite surface. An expansion buffer insert (26) has bond wire openings and is coupled to the first surface of the interposer (16). A semiconductor chip (12) is coupled to an opposite surface of the expansion buffer insert (26) and is connected to the traces via bond wires. The package (24) then has a mold compound (18) encasing the semiconductor chip (12) and the expansion buffer insert (26). In one embodiment, the expansion buffer insert (26) is a copper plate.

## Description

This invention relates in general to the field of semiconductor chip packaging, and more particularly to a ball grid array package.

Ball grid array packages (e.g., the µStar BGA package available from TEXAS INSTRUMENTS) are near chip sized packages for packaging semiconductor chips. Conventionally ball grid array packages are provided with underfill when the package is attached to a printed circuit board in order to improve solder ball lifetimes. The need for underfill arises from the fact that the effective expansion of the package is closer to that of the semiconductor chip (e.g., silicon) than that of the printed circuit board. As a result, without the underfill to alleviate the stress, high solder stress would occur, and the solder balls would eventually fail after repeatedly being stressed. However, the underfill adds a time consuming step to the manufacturing process and limits reworkability.

Particular and preferred aspects of the invention are set out in the accompanying independent and dependent claims. Features of the dependent claims may be combined with those of the independent claims as appropriate and in combinations other than those explicitly set out in the claims.

In accordance with the present invention, a ball grip array package having an expansion buffer insert and a method of construction are provided. Through the provision of an expansion buffer insert it is possible to avoid having to use underfill in the package.

According to one aspect of the present invention, the ball grid array package includes an interposer having traces on a first surface and associated solder balls on an opposite surface. An expansion buffer insert is provided and has bond wire openings and is coupled to the first surface of the interposer. A semiconductor chip is coupled to an opposite surface of the expansion buffer insert and is connected to the traces via bond wires. The package then has a mold compound encasing the semiconductor chip and the expansion buffer insert. In one embodiment the expansion buffer insert is a copper plate.

According to another aspect of the present invention, a method is provided for manufacturing a ball grid array package. An expansion buffer insert is attached to a first surface of all interposer, where the expansion buffer insert has bond wire openings and the interposer has traces on the first surface and associated solder balls on an opposite surface. A semiconductor chip is attached to an opposite surface of the expansion buffer insert and connected to the traces via bond wires. The semiconductor chip and the expansion buffer insert are then encased in a mold compound. In certain embodiments, the expansion buffer insert and interposer can be singulated (formed as a single unit) or can be formed as one of many on a strip.

It is thus possible to eliminate the need for underfill by reducing the stress on solder balls through the addition of an embedded expansion buffer insert (e.g., a copper plate) between the semiconductor chip and the interposer in a ball grid array package.

The expansion buffer insert may advantageously have a thickness that is similar to a standard lead frame thickness, in which case the expansion buffer insert can form a part of a lead frame complete with index holes and to which the interposer can be attached. Thus, traditional mount, bond and mold equipment can be used to manufacture the ball grid array package with the expansion buffer insert. Also, interposer material usage is minimized.

The expansion buffer insert may advantageously have a high thermal conductivity to provide improved thermal performance resulting from the good heat spreading abilities of the expansion buffer insert.

Further technical advantages should be apparent from the drawings, description and claims.

A more complete understanding of the present invention and advantages thereof may be acquired by referring to the following description taken in conjunction with the accompanying drawing, in which like reference numbers indicate like features, and wherein:
FIGURE 1 is a cross-sectional view of a conventional ball grid array package attached to a printed circuit board and having underfill;
FIGURE 2 is a cross-sectional view of one embodiment of a ball grid array package attached to a printed circuit board and having an expansion buffer insert;
FIGURE 3 is a perspective view of one embodiment of a copper plate expansion buffer insert between a semiconductor chip and interposer tape;
FIGURE 4 is a cross-section of the interposer tape of FIGURE 3; and
FIGURE 5 is a perspective view of one embodiment of a copper lead frame strip and a singulated interposer for use in manufacturing ball grid array packages.

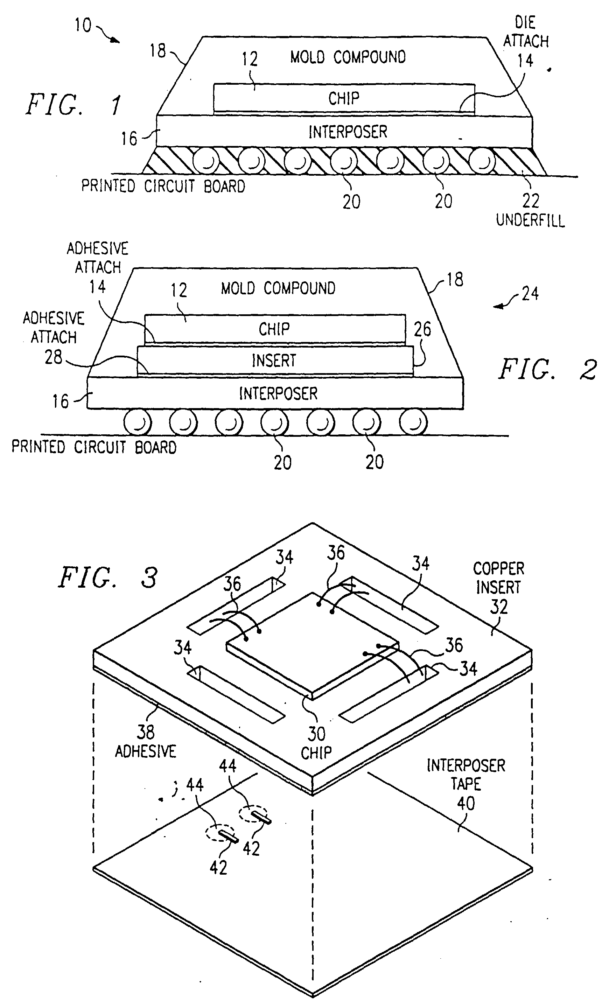

FIGURE 1 is a cross-sectional view of a conventional ball grid array package, indicated generally at 10, attached to a printed circuit board and having underfill. As shown, package 10 includes a semiconductor chip 12 having a die attach layer 14 (e.g., adhesive) that connects chip 12 to an interposer 16. A mold compound 18 encases chip 12 and die attach 14 to protect chip 12 from the external environment. A plurality of solder balls are coupled to interposer 16 and provide connections to a printed circuit board, as shown. Underfill 22 is provided between interposer 16 and the printed circuit board and is formed from a material that reduces the effect of thermal expansion. The purpose of underfill 22 is to alleviate stress on solder balls 20 due to thermal expansion mismatch between package 10 and the printed circuit board and thereby extend the lifetime of solder balls 20. As mentioned above, the process of adding underfill 22 is time-consuming and is performed after package 10 has been mounted on the printed circuit board.

FIGURE 2 is a cross-sectional view of one embodiment of a ball grid array package, indicated generally at 24, attached to a printed circuit board and having an expansion buffer insert. As shown, package 24 is similar to package 10 of FIGURE 1. An expansion buffer insert 26 is positioned between chip 12 and interposer 16 and is attached to interposer 16 by an electrically isolating adhesive attach 28. Insert 26 can be constructed from copper or other material to provide a thermal expansion more similar to that of the printed circuit board.

In general, the thermal cycling performance of ball grid array package 24 is a strong function of the printed circuit board material in thickness. By inserting expansion buffer insert 26 (such as a copper plate) under chip 12, the strain on solder balls 20 can be reduced (e.g., 3%) for the same thermal conditions. Chip 12 may then experience a higher stress (e.g., 10% more). However, chip 12 can withstand such stress without damage or fatigue. Consequently, insert 26 reduces the stress on and extends the lifetime of solder balls 20 without the need for underfill 22 and without degrading performance of chip 12.

FIGURE 3 is a perspective view of one embodiment of a copper plate expansion buffer insert between a semiconductor chip and interposer tape. As shown, a chip 30 can be attached to a copper plate 32 which operates as an expansion buffer insert. Copper plate 32 can include bond wire cut-outs 34 that provide openings for bond wires 36 to pass from chip 30 to contacts below copper plate 32. An electrically isolating adhesive layer 38 is coupled to copper plate 32 and provides a means for attaching copper plate 32 to interposer tape 40. Interposer tape 40 can include copper traces 42 that provide electrical connections from bond wires 36 to solder balls 44 that are positioned on the underside of interposer tape 40. It should be understood that a typical interposer tape 40 would include numerous traces 42 and solder balls 44.

Copper plate 32 provides thermal cycling performance improvement for the ball grid array package. By matching copper plate 32 with the printed circuit board to produce similar thermal expansion above and below solder balls 44, the stress on solder balls 44 can be reduced without the need for underfill. Of course, copper plate 32 or other expansion buffer insert can produce additional stress on chip 30. However, chip 30, like most semiconductors (e.g., silicon), can be stressed numerous times without damage because chip 30 does not suffer from fatigue as do solder balls 44. Thus, the use of an expansion buffer insert such as copper plate 32 removes the need for underfill by better matching the thermal expansion of the printed circuit board.

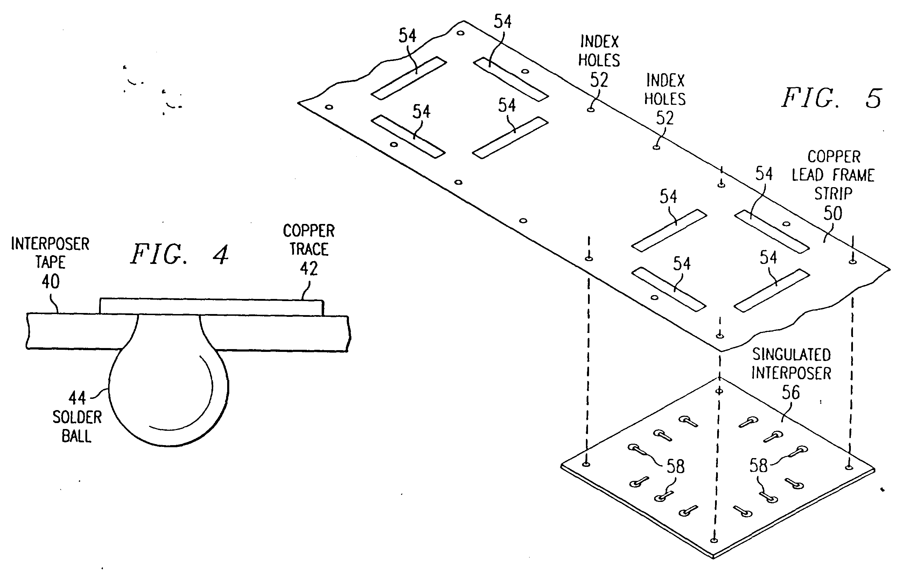

FIGURE 4 is a cross-sectional view of interposer tape 40 of FIGURE 3. As shown, interposer tape 40 provides a structure for copper traces 42 and solder balls 44. After attaching interposer tape 40 to insert 32, connections can then be made between bond wires 36 and traces 42, thus connecting chip 30 to the printed circuit board through solder balls 44.

FIGURE 5 is a perspective view of one embodiment of a copper lead frame strip and a singulated interposer for use in manufacturing ball grid array packages. As shown, a copper lead frame strip 50 can include index holes 52 defining separate copper plate expansion buffer inserts. Each copper plate insert has a plurality of associated bond wire cut-outs 54 similar to those shown in FIGURE 3. A singulated interposer 56 can be attached to copper lead frame strip 50 to form a base component for packaging semiconductor chips. Singulated interposer 56 can have copper traces 58 that receive bond wire connections through bond wire cut-outs 54. Traces 58 connect to associated solder balls on the underside of singulated interposer 56. Once singulated interposers 56 are attached to each copper plate insert, the combination can be used with existing manufacturing equipment to manufacture ball grid array packages.

In alternate embodiments, interposer 56 can be provided in a lead frame strip. The expansion buffer inserts may be singulated. Further, both the expansion buffer inserts and interposers 56 can be provided in lead frame strips that are attached together. This can allow traditional mount, bond and mold equipment to be used to manufacture ball grid array packages with expansion buffer inserts.

Although the present invention has been described in detail, it should be understood that various changes, substitutions and alterations can be made thereto without departing from the spirit and scope of the invention.

## Claims

1. A ball grid array package, comprising:
an interposer having traces on a first surface and associated solder balls on an opposite surface;
an expansion buffer insert having bond wire openings, the expansion buffer insert having a first surface coupled to the first surface of the interposer;
a semiconductor chip coupled to an opposite surface of the expansion buffer insert, the semiconductor chip connected to the traces via bond wires; and
a mold compound encasing the semiconductor chip and the expansion buffer insert.

2. A method of manufacturing a ball grid array package, comprising:
attaching a first surface of an expansion buffer insert to a first surface of an interposer, where the expansion buffer insert has bond wire openings, and where the interposer has traces on the first surface and associated solder balls on an opposite surface of the interposer;
attaching a semiconductor chip to an opposite surface of the expansion buffer insert;
connecting the semiconductor chip to the traces via bond wires; and
encasing the semiconductor chip and the expansion buffer insert in a mold compound.

3. The package of claim 1 or the method of claim 2, wherein the expansion buffer insert is one of a plurality of expansion buffer inserts.

4. The package or method of claim 3, wherein the expansion buffer inserts are formed in a lead frame strip.

5. The package or method of claim 4, wherein the lead frame strip is a copper lead frame strip.

6. The package of claim 1 or the method of claim 2, wherein the expansion buffer insert is a singulated insert.

7. The package or method of any one of the preceding claims, wherein the interposer is a singulated interposer.

8. The package or method of any one of claims 1 to 6, wherein the interposer is one of a plurality of interposers.

9. The package or method of claim 8, wherein the plurality of interposers are formed in the, a or a further lead frame strip.

10. The package or method of any one of the preceding claims, wherein the expansion buffer insert is a copper plate.

11. The package or method of any one of the preceding claims, wherein the bond wire openings are formed by cut-outs in the or each expansion buffer insert.

12. The package or method of any one of the preceding claims, wherein the traces are copper traces.

13. The package or method of any one of the preceding claims, wherein the expansion buffer insert is coupled to the interposer by an adhesive attach layer, preferably by an electrically isolating adhesive attach layer.

14. The package or method of any one of the preceding claims, wherein the semiconductor chip is attached to the expansion buffer insert by an adhesive attach layer.
